**Europäisches Patentamt**

**European Patent Office**

**Office Européen des brevets**

(11) Veröffentlichungsnummer : **0 222 203 B1**

# (12) EUROPÄISCHE PATENTSCHRIFT

(45) Veröffentlichungstag der Patentschrift :
**02.01.91 Patentblatt 91/01**

(51) Int. Cl.⁵ : **H01L 25/18, H01L 25/04**

(21) Anmeldenummer : **86114402.0**

(22) Anmeldetag : **17.10.86**

(54) **Leistungshalbleitermodul.**

(30) Priorität : **15.11.85 CH 4897/85**

(43) Veröffentlichungstag der Anmeldung :
**20.05.87 Patentblatt 87/21**

(45) Bekanntmachung des Hinweises auf die
Patenterteilung :
**02.01.91 Patentblatt 91/01**

(84) Benannte Vertragsstaaten :
**CH DE FR GB IT LI SE**

(56) Entgegenhaltungen :
**EP-A- 0 111 659**
**DE-A- 3 336 979**
**DE-A- 3 409 146**
**DE-A- 3 501 985**
**FR-A- 2 529 013**

(73) Patentinhaber : **BBC Brown Boveri AG**
**Haselstrasse**
**CH-5401 Baden (CH)**

(72) Erfinder : **Broich, Bruno, Dr.**
**Pilgerstrasse 83**
**CH-5405 Baden (CH) (CH)**
Erfinder : **Gobrecht, Jens, Dr.**
**Brühlstrasse 37**
**CH-5412 Gebenstorf (CH)**
Erfinder : **Roggwiller, Peter, Dr.**
**Püntstrasse 16**
**CH-8173 Riedt-Neerach (CH)**

## Beschreibung

Die Erfindung bezieht sich auf ein Leistungshalbleitermodul mit mindestens einem Bipolar-Halbleiterelement und einem MOS-Halbleiterelement in Kaskodeschaltung.

Für die Ansteuerung von bipolaren Leistungshalbleiterelementen sind Kombinationen mit Niederspannungs-Hoch-strom-MOSFETs bekannt, in denen der Laststrom des bipolaren Leistungshalbleiters beim Abschalten auf den Steueranschluss kommutiert wird. Die bekannteste Anordnung dieser Art ist die Kaskodeschaltung, deren grundsätzlicher Aufbau und Wirkungsweise z.B. in dem DE-Buch "Lexikon der Elektronik" Friedrich Vieweg - Sohn Braunschweig/Wiesbaden 1983, S. 228 u. 229, beschrieben sind. Als bipolarer Leistungshalbleiter können feldkontrollierte Thyristoren (FCTh), GTO-Thyristoren oder (Darlington-) Transistoren eingesetzt werden.

Die wesentlichen Vorteile der Kaskodeschaltungen bestehen darin, dass die Ansteuerung des Schalters bei geringem Energieverbrauch über das MOS-Gate des Leistungs-MOSFET erfolgt und hohe Schaltgeschwindigkeiten und -frequenzen erreicht werden können.

Letzteres erfordert jedoch einen kompakten auf die hohen Schaltgeschwindigkeiten und -frequenzen abgestimmten Aufbau mit definierter Leitungsführung zwischen den Bauelementen der Kaskode.

Der Erfindung, wie sie in den Patentansprüchen gekennzeichnet ist, liegt daher die Aufgabe zugrunde, einen Leistungshalbleitermodul der eingangs genannten Gattung zu schaffen, welcher diesen Forderungen gerecht wird. Durch den erfindungsgemässen Aufbau des Moduls liegen die die thermischen und elektrischen Eigenschaften des Moduls im wesentlichen bestimmenden Einflussparameter ein für allemal fest und können bereits zu einem frühen Zeitpunkt der Modul-Entwicklung optimiert werden. Der Austausch defekter Module ist ohne Beeinträchtigung der Gesamtfunktion möglich.

Durch die Ausgestaltung des Moduls nach den Patentansprüchen 2 und 3 lassen sich darüber hinaus die Kaskodenschaltung von MOS- und Bipolar-Halbleiterelementen anhaftenden Unzulänglichkeiten mit Sicherheit vermeiden.

Nachteilig bei der Kaskodeschaltung ist, dass der MOSFET in Serie zum bipolaren Leistungshalbleiter geschaltet ist und sich dessen Schalt-und Durchlassverluste zu denen des bipolaren Leistungshalbleiters addieren. Die erreichbaren Schaltleistungen und Taktfrequenzen hängen somit wesentlich von der Kühleffizienz beider Bauelemente ab. Während bei bipolaren Bauelementen die Chipfläche leicht vergrössert und somit die anfallende Verlustwärme auf eine grössere Kontaktfläche verteilt werden kann, ist dies bei MOSFETs aus technologischen Gründen nur schwer möglich. Typischerweise sind Leistungs-MOSFETs heute kleiner als ein halber $cm^2$, wohingegen der bipolare Leistungshalbleiter für die gleiche Stromtragfähigkeit ein bis zwei $cm^2$ in der Fläche ausgelegt wird. Nachdem beide Bauelemente in der Kaskodeschaltung den gleichen Strom führen, ist beim kleineren MOSFET die anfallende Verlustleistungsdichte in der Regel einen Faktor 2-3 grösser als beim bipolaren Bauelement. Damit die Kaskode bis an die Grenze ihrer Schaltleistung ausgefahren werden kann, muss die Kühlung insbesondere des MOSFET-Chips besonders effizient ausgelegt werden.

Besonders gut geeignet für den hybriden Aufbau der Kaskode aus Bipolar-Chip und MOS-Chip ist die an sich bekannte Modultechnik. In der Modultechnik werden mindestens zwei Halbleiter-Chips als Elemente einer Schaltung gegeneinander isoliert auf der gleichen metallischen Grundplatte montiert. Zwischen der Metall-Grundplatte und einzelnen Metall-Kontaktplatten, auf denen die Chips aufgelötet sind, liegt eine isolierende Keramikplatte. Neben der funktionalen Zusammenfassung mehrerer Bauelemente in einem Gehäuse, besteht die Idee beim Modul darin, die bei jedem Element anfallenden Wärmeverluste über die Keramikplatte in die gleiche Metall-Grundplatte abzuleiten und diese ausreichend zu kühlen. In diesem Sandwich aus Halbleiter-Chip-Metallkontaktplatte-Keramikplatte-Metallgrundplatte bildet die Keramikplatte den grössten Wärmewiderstand. Die Keramikplatte bewirkt einerseits die elektrische Isolierung der auf ihren Metallkontaktplatten montierten Halbleiter-Chips untereinander und die elektrische Isolierung der Metallgrundplatte, die somit potentialfrei auf einen Kühlkörper montiert werden kann.

Das Problem der Wärmeabfuhr bei hybriden Kombinationen von MOS- und Bipolar-Bauelementen in Modultechnik wird in der neuen Literatur häufig angesprochen. So wird im Aufsatz "Modules with solder contacts for high power applications" von Arno Neidig in Conf. Rec. 19th Ann. Meeting of IEEE Ind. Appl. Soc., Oct. 84, p. 723, vorgeschlagen, die bisher üblichen Aluminiumoxid-Substrate durch solche auf Aluminiumnitrid-Basis zu ersetzen, welche eine grössere Wärmeleitfähigkeit aufweisen als Aluminiumoxid-Keramik, oder ein Wärmerohr (heat pipe) in das Substrat zu integrieren, um die Verlustwärme seitlich aus dem Modul abzuführen. Beide Technologien sind jedoch bis dato technisch nicht über das Versuchsstadium hinaus gelangt und eine kommerzielle Anwendung ist nicht absehbar.

Durch die Weiterbildung der Erfindung, wie sie in den Patentansprüchen 2 und 3 gekennzeichnet ist, erhält man einen Leistungshalbleitermodul, der mit den heute zur Verfügung stehenden Materialien und Technologien hergestellt und wirkungsvoll gekühlt werden kann.

Durch die unmittelbare Montage des MOS-Halbleiterelements auf der metallischen Trägerplatte ist der Wärmeübergangswiderstand vom MOS-Element zur Grundplatte um eine Grössenordnung (typisch um den Faktor 20) kleiner als der vom Bipolar-Element zur Grundplatte Aluminiumoxid als Keramikmaterial ; das MOS-Halbleiterelement wird im Vergleich zum Bipolar-Halbleiterelement besonders wirkungsvoll gekühlt.

Einen noch induktionsärmeren Aufbau erreicht man, wenn der Modul gemäss Anspruch 6 in Sandwich-Bauweise ausgebildet ist, wobei die beiden Halbleiterelemente übereinander liegen und ihre Hauptstromwege damit in Serie liegen.

Die Erfindung, ihre besonderen Ausgestaltungen und die erzielbaren Vorteile werden nachfolgend anhand von in der Zeichnung dargestellten Ausführungsbeispielen näher erläutert.

In der Zeichnung zeigt

Fig. 1 die Kaskodeschaltung eines MOS-Halbleiterelements und eines feldkontrollierten Thyristors,

Fig. 2 den schematischen Aufbau der Kaskodenschaltung nach Fig. 1 in Hybridtechnik mit einseitiger Kühlung,

Fig. 3 den schematischen Aufbau der Kaskodenschaltung nach Fig. 1 in Hybridtechnik mit beidseitiger Kühlung,

Fig. 4 die Kaskodeschaltung eines MOS-Halbleiterelements und eines GTO-Thyristors,

Fig. 5 die Kaskodeschaltung eines MOS-Halbleiterelements und eines Darlington-Transistors,

Fig. 6 den schematischen Aufbau der Kaskode nach Fig. 4 bzw. 5 in Hybridtechnik mit einseitiger Kühlung.

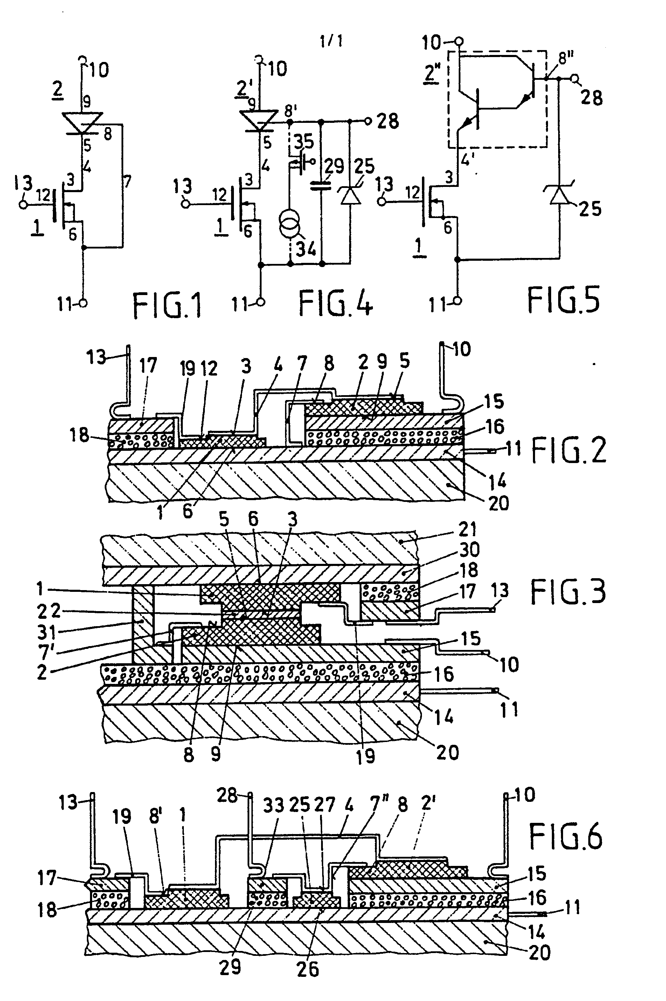

In der Schaltung nach Fig. 1 sind ein n-Kanal-Leistungs-MOS-Transistor 1 und ein feldkontrollierter Thyristor (FCTh) 2 in Kaskode geschaltet. Zu diesem Zweck ist der Source-Anschluss 3 des MOS-Transistors 1 über eine erste Verbindungsleitung 4 an die Kathode 5 des Thyristors 2, der Drain-Anschluss 6 des MOS-Transistors 1 über eine zweite Verbindungsleitung 7 mit dem Gate 8 des Thyristors 2 verbunden. Die Anode 9 des Thyristors 2 und der Drain-Anschluss 6 des MOS-Transistors 1 bilden die beiden Haupt- oder Hochstromklemmen 10, 11, der Gate-Anschluss 12 des MOS-Transistors 1 die Steuerklemme 13 der Kaskode.

In der beispielsweisen, praktischen Ausführung einer Thyristor-MOS-Transistor-Kaskode in Modultechnik nach Fig. 2 sind die beiden Halbleiterchips (MOS-Transistor 1, FCTh-Thyristor 2) sowie ihre zugehörigen Anschlüsse mit denselben Bezugszeichen wie in Fig. 1 versehen und liegen nebeneinander auf einer metallischen Trägerplatte 14. Der Drain-Kontakt 6 des MOS-Transistors 1 ist unmittelbar mit der metallischen Trägerplatte 14 verbunden, vorzugsweise mit dieser verlötet. Der Thyristor 2 ist mit seinem Anodenkontakt 9 unter Zwischenschaltung einer Metall-Kontaktplatte 15 auf eine metallisierte Keramikplatte 16 aufgelötet. Diese Keramikplatte 16 ist ihrerseits auf die Trägerplatte 14 aufgelötet. Die Verbindungsleitungen 4 und 7 zwischen Source 3 und Kathode 5 bzw. zwischen Drain 6 und Gate 8 sind als Metallstreifen bzw. Kontaktbügel 4 bzw. 7 ausgeführt. Dabei führt der Metallstreifen 7 auf kürzestem Wege vom Gatekontakt 8 zur Trägerplatte 14 im Zwischenraum zwischen den beiden Chips 1 und 2. Der Metallstreifen 4 verbindet gleichfalls auf kürzestem Wege - unter Einhaltung des notwendigen Isolationsabstandes - den Kathodenkontakt 8 des Thyristors 2 mit dem Source-Kontakt 3 des MOS-Transistors 1.

Die beiden Metallstreifen 4 und 7 bilden eine Leiterschleife, die in der gezeigten Anordnung besonders induktionsarm, d.h. mit geringem Flächenquerschnitt, aufgebaut werden kann. Der induktionsarme Aufbau ist in einer Kaskodenschaltung besonders wichtig, damit zeitlich sich schnell ändernde Schaltströme keine zu grossen Ueberspannungen in der Leiterschleife induzieren und hierdurch Bauelemente zerstören.

Die Steuerklemme 13 der Kaskode ist nicht unmittelbar am Gate-Kontakt 12 des MOS-Transistors 1 angeschlossen ; sie führt vielmehr zu einer Metallplatte 17, die über eine Isolierplatte 18, z.B. aus $Al_2O_3$-Keramik, mit der Trägerplatte 14 verlötet ist. Die elektrische Verbindung zwischen Gate-Kontakt 12 und Metallplatte 17 erfolgt durch einen Kontaktbügel 19. Die Trägerplatte 14 und die Kontaktplatte 15 bilden die Hochstromklemmen 10, 11 der Kaskode bzw. des Moduls, wobei die Klemmen 10, 11 als Anschlussfahnen, die mit der Kontaktplatte 15 bzw. der Trägerplatte 14 verlötet ist, ausgebildet sind.

Der Modul kann als Ganzes auf einen Kühlkörper 20 grossflächig befestigt werden, wobei auch der Kühlkörper 20 die andere Hochstromklemme 11 des Moduls bilden kann.

Zu einem noch wesentlich induktivitätsärmeren Aufbau einer Kaskode-Schaltung in Hybrid-Technik gelangt man, wenn gemäss Fig. 3 das MOS-Halbleiterelement 1 unmittelbar mit dem Bipolar-Halbleiterelement 2 elektrisch verbunden wird. In Fig. 3 sind die gleichen Teile wie in Fig. 2 mit denselben Bezugszeichen versehen. Die mit der Sandwich-Anordnung nach Fig. 3 realisierte Schaltung entspricht derjenigen von Fig. 1.

Wie in Fig. 2 ist das Bipolar-Halbleiterelement 2 mit seinem Anodenkontakt 9 unter Zwischenschaltung einer Metall-Kontaktplatte 15 und einer metallisierten Keramikplatte 16 auf der unteren Trägerplatte 14 befestigt. Der Source-Kontakt 3 des MOS-Halbleiterelements 1 ist direkt auf den Kathodenkontakt 5 des Bipolar-Halbleiterelements 2 gelötet, legiert oder mit einem leitfähigen Kleber geklebt (Zwischenschicht 22 in Fig. 3). Wo aus konstruktiven Gründen ein grösserer Abstand zwischen den beiden Halbleiterelementen 1, 2 vorhanden sein muss, tritt an die Stelle dieser Schicht 22 eine entsprechend dicke Zwischenplatte aus Metall oder Silizium.

Der Drain-Kontakt 6 des MOS-Halbleiterelements 1 ist direkt mit einer zweiten metallischen Trägerplatte 30 verbunden.

Beide Trägerplatten 14 und 30 sind grossflächig mit Kühlkörpern 20, 21 verbunden. Die Hochstromklemmen 10, 11 und die Steuerklemme 13 der Kaskode sind seitlich herausgeführt, wobei die Kontaktierung der Steuerklemme analog zu Fig. 2 mittels Kontaktbügel 19 und Metallplatte 17 bewerkstelligt ist. Die nach der Schaltung gemäss Fig. 1 notwendige Verbindung zwischen dem Gatekontakt 8 des Bipolar-Halbleiterelements 2 und dem Drain-Anschluss 6 des MOS-Halbleiterelements 1 erfolgt über einen Kontaktbügel 7' der an einen Kontaktstempel 31 führt, der zwischen der Keramikplatte 16 und der zweiten Trägerplatte 30 angeordnet ist und gleichzeitig zur Distanzierung des Sandwich dient.

Kathoden- und Sourcebereich beider Chips sind vorteilhaft so ausgelegt, dass die Flächen stoffschlüssig gut miteinander verbunden werden können und die Gatebereiche nicht übereinanderzuliegen kommen, so dass metallische Anschlussklemmen seitlich von den Gates fortgeführt werden können. Hierzu kann es ebenfalls erforderlich sein, den Abstand zwischen den Chips über die Dicke der elektrisch leitfähigen Zwischenschicht 22 zu vergrössern.

In beiden erfindungsgemässen Strukturen entsprechend den Figuren 2 und 3 kann der Modul neben dem MOS- und dem Bipolar-Chip zusätzliche Bauelemente, die untereinander elektrisch verbunden sind, beinhalten. In der beidseitig kühlbaren Struktur gemäss Fig. 3 können komplexere Schaltungen mit mehreren Bauelementen besonders effizient und platzsparend miteinander verbunden werden. Derartige Sandwichmodule sind z.B. in der DE-OS 34 06 528 beschrieben.

Wird die Kaskode gemäss Fig. 4 mit einem GTO-Thyristor oder einem Darlington-Transistor (Fig. 5) aufgebaut, ist ein zusätzlicher Steueranschluss 28 am Gate 8' des GTO-Thyristors 2' bzw. Steueranschluss 8" des Darlington-Transistors 2" erforderlich, der über einer Zenerdiode 25 mit der Klemme 11 verbunden ist. Ein erfindungsgemässer Modulaufbau ist in Fig. 6 schematisch dargestellt. Natürlich müssen die Halbleiter-Elemente nicht ausschliesslich hintereinander angeordnet sondern können auch nebeneinander angeordnet sein, um einerseits die Fläche kleinzuhalten und andererseits die Ueberbrückungselemente günstig anzuordnen.

So ist im Modul nach Fig. 6 zwischen dem MOS-Halbleiterbauelement 1 und dem Bipolar-Halbleiterelement 2', hier ein GTO-Thyristor, eine Zenerdiode 25 mit ihrem Anodenanschluss 26 unmittelbar auf der Trägerplatte 14 angeordnet, die kathodenseitig mit dem Gateanschluss 8' des GTO-Thyristors 2' über einen Kontaktbügel 7" verbunden ist. Dieser Kontaktbügel führt gleichzeitig an den zusätzlichen Steueranschluss 28 der Kaskode. Der parallel zur Zenerdiode 25 geschaltete Kondensator 29 (Fig. 4) ist gleichfalls in Hybridtechnik in den Modul integriert und ist als dielektrische Schicht 29 zwischen einer Metallplatte 33, die die Klemme 28 trägt, und der Trägerplatte 14 veranschaulicht.

Mit der Schaltung gemäss Fig. 4 bzw. der Realisierung in Hybrid-Technik gemäss Fig. 6 kann auf ein sonst notwendiges aktives Bauelement, z.B. eine Stromquelle 34 in Reihe mit einem p-Kanal-MOS-Transistor 35 (strichliert in Fig. 4 angedeutet) verzichtet werden. Sowohl der Einschalt- als auch der Ausschaltvorgang lassen sich über das Gate 12 des MOS-Halbleiterelements 1 im Lastkreis steuern. Der notwendige Gate-Strom zum Zünden des GTO-Thyristors 2' liefert der Kondensator 29 sobald der MOS-Transistor 1 leitet. Wird durch Sperren des MOS-Transistors 1 der Laststrom ausgeschaltet, so fliesst kurzzeitig ein negativer Gatestrom, der ungefähr dem vorherigen Laststrom entspricht, in den Kondensator 29, so dass für den nächsten Einschaltvorgang wieder ausreichend Ladung zur Verfügung steht. Folgt während längerer Zeit keine erneute Zündung, so kann eine Entladung des Kondensators verhindert werden, wenn gewährleistet ist, dass der Leckstrom von Zenerdiode, MOS-Transistor und Kondensator kleiner ist als derjenige des GTO-Thyristors. Die im Kondensator zwischengespeicherte Ausschaltenergie wird in der vorliegenden Erfindung wieder zum Einschalten des GTOs verwendet.

Die angegebene Schaltung lässt sich, unter Verwendung von GTO-Thyristoren mit fein strukturierter Steuerzone, besonders sicher realisieren, da diese Bauelemente auch bei hohen Lastströmen mit einer Abschaltverstärkung von ~ 1 abgeschaltet werden können.

## Ansprüche

1. Leistungshalbleitermodul mit mindestens einem Bipolar-Halbleiterelement (2 ; 2' ; 2") und einem MOS-Halbleiterelement (1) in Kaskode-Schaltung, dadurch gekennzeichnet, dass das Bipolar-Halbleiterelement (2 ; 2' ; 2") direkt oder über metallische Ausgleichsstücke mit einer Metallisierung auf einem ersten isolierenden Substrat unter dem Bipolar-Halbleiterelement (2) kontaktiert ist, welches Substrat (16) seinerseits auf einer ersten metallischen Trägerplatte (14) angeordnet ist, und dass das MOS-Halbleiterelement (1) unmittelbar neben dem Bipolar-Halbleiterelement (2) auf derselben Metallplatte (14) oder auf der dem Bipolar-Halbleiterelement (2) zugewandten Oberfläche einer zweiten Trägerplatte (30) über dem Bipolar-Halbleiterelement (2) angeordnet ist, und die elektrischen Verbindungen zwischen den beiden Halbleiterelementen durch unmittelbare Kontaktierung und/oder durch Kontaktbügel (4, 19) realisiert sind, und dass zumindest die dem Bipolar-Halbleiterelement abgewandte Oberfläche der ersten Trägerplatte (14) mit einem Kühlkörper (20) kontaktierbar ist.

2. Leistungshalbleitermodul nach Anspruch 1, dadurch gekennzeichnet, dass das MOS-Halbleiterelement (1) unmittelbar auf der ersten metallischen Trägerplatte (14) neben dem Bipolar-Halbleiterelement (2) angeordnet ist (Fig. 2).

3. Leistungshalbleitermodul nach Anspruch 2, dadurch gekennzeichnet, dass die ersten Hauptanschlüsse (3, 5) der Halbleiterbauelemente (1, 2) unmittelbar über einen ersten Kontaktbügel (4) miteinander verbunden sind, dass der zweite Hauptanschluss (9) des Bipolar-Halbleiterelements an eine erste Hauptstromklemme (10) des Moduls geführt ist, dass der Steueranschluss (8) des Bipolar-Halbleiterelements über einen zweiten Verbindungsbügel (7), unterhalb des ersten Bügels und von diesem beabstandet an die erste Trägerplatte (14) geführt ist, welche erste Trägerplatte (14) die zweite Hauptstromklemme (11) des Moduls bildet, und dass der Steueranschluss (12) des MOS-Halbleiterelements an eine weitere Klemme, die Steuerklemme (13) des Moduls, geführt ist.

4. Leistungshalbleitermodul nach Anspruch 3, dadurch gekennzeichnet, dass im Zuge des zweiten Verbindungsbügels (7) eine Zener-Diode (25) eingeschaltet ist, die mit ihrem Anodenanschluss (26) unmittelbar auf der ersten Trägerplatte (14) liegt und deren Kathodenanschluss mit dem zweiten Bügel (7) verbunden ist.

5. Leistungshalbleitermodul nach einem der Ansprüche 1 bis 4, dadurch gekennzeichnet, dass das Bipolar-Halbleiterelement eine Darlington-Transistoranordnung (2") oder ein feldkontrollierter Thyristor (2') ist, deren Steueranschluss (8', 8") an eine zweite, separate Steuerklemme (28) geführt ist.

6. Leistungshalbleitermodul nach Anspruch 1, dadurch gekennzeichnet, dass die zweite Trägerplatte (30) aus Metall besteht, wobei die Distanzierung zwischen der ersten (15) und zweiten Trägerplatte (30) durch die beiden Halbleiterelemente (1, 2) selbst und/oder durch Distanzstücke aus Isoliermaterial bewirkt ist.

7. Leistungshalbleitermodul nach Anspruch 6, dadurch gekennzeichnet, dass das Bipolar-Halbleiterelement ein Thyristor (2 ; 2') ist, das MOS-Halbleiterelement ein Leistungs-MOSFET ist, und der Kathodenanschluss (5) des Thyristors (2 ; 2') über eine elektrisch leitende Zwischenschicht (22) unmittelbar mit dem Source-Anschluss (3) des MOSFET (1) verbunden ist.

8. Leistungshalbleitermodul nach Anspruch 6 oder 7, dadurch gekennzeichnet, dass die Kontaktklemmen (10, 11, 13) des Moduls seitlich herausgeführt sind und beide freien Oberflächen der Trägerplatten (14, 30) mit je einem Kühlkörper (20, 21) kontaktierbar sind.

## Claims

1. Power semiconductor module having at least one bipolar semiconductor element (2 ; 2' ; 2") and an MOS semi-conductor element (1) in cascode circuit, characterized in that the bipolar semiconductor element (2 ; 2' ; 2") is contacted directly or via metallic compensating elements with a metallization on a first insulating substrate under the bipolar semiconductor element (2), which substrate (16), for its part, is disposed on a first metallic carrier plate (14) and characterized in that the MOS semiconductor element (I) is disposed directly beside the bipolar semiconductor element (2), on the same metal plate (14) or on the surface - facing the bipolar semiconductor element (2) -of a second carrier plate (30) above the bipolar semiconductor element (2), and the electrical connections bethween the two semiconductor elements are made by direct contacting and/or by contact bridge elements (4, 19), and wherein at least the surface - remote from the bipolar semiconductor element - of the first carrier plate (14) is contactable with a cooling body (20).

2. Power semiconductor module according to Claim 1, characterized in that the MOS semiconductor element (t) is disposed directly on the first metallic carrier plate (14) beside the bipolar semiconductor element (2) (Fig.2),

3. Power semiconductor module according to Claim 2, characterized in that the first principal connections (3, 5) of the semiconductor components (1, 2) are connected to one another directly via a first contact bridge element (4), in that the second principal connection (9) of the bipolar semiconductor element is directed to a first principal current terminal (10) of the module, in that the drive connection (8) of the bipolar semiconductor element is directed to the first carrier plate (14) via a second connecting bridge element disposed below the first bridge element and spaced from the latter, which first carrier plate (14) forms the second principal current terminal (11) of the module, and in that the drive connection (12) of the MOS semiconductor element is directed to a further terminal, the drive terminal (13) of the module.

4. Power semiconductor module according to Claim 3, characterized in that in the course of the second connecting bridge element (7) a Zener diode (25) is connected, which is located by its anode connection (26) directly on the first carrier plate (14) and the cathode connection of which is connected to the second bridge element (7).

5. Power semiconductor module according to one of Claims 1 to 4, characterized in that the bipolar semiconductor element is a Darlington transistor arrangement (2") or a field-controlled thyristor (2'), the drive connection (8', 8") of which is directed to a second, separate drive terminal (28).

6. Power semiconductor module according to Claim I, characterized in that the second carrier plate (30) consists of metal, the distancing between the first (15) and second carrier plate (30) being effected by the two semiconductor elements (I, 2) themselves and/or by distance pieces of insulating material.

7. Power semiconductor module according to Claim 6, characterized in that the bipolar semiconductor element is a thyristor (2 ; 2'), the MOS semiconductor element is a power MOSFET, and the cathode connection (5) of the thyristor (2 ; 2') is directly connected via an electrically conductive intermediate layer (22) to the source connection (3) of the MOSFET (1).

8. Power semiconductor module according to Claim 6 or 7, characterized in that the contact terminals (10, 11, 13) of the module are directed out laterally, and both free surfaces of the carrier plates (14, 30) are contactable with respective cooling bodies (20, 21).

## Revendications

1.- Module semi-conducteur de puissance comportant au moins un composant semi-conducteur bipolaire (2 ; 2' ; 2") et un composant semi-conducteur MOS (1) dans un montage cascode, caractérisé en ce que le composant semiconducteur bipolaire (2 ; 2' ; 2") est en contact direct ou par l'intermédiaire de pièces d'égalisation métalliques avec une métallisation présente sur un premier substrat isolant en-dessous du composant semi-conducteur bipolaire (2), ce substrat (16) étant pour sa part disposé sur une première plaque de support métallique (14), et que le composant semiconducteur MOS (1) est disposé immédiatement à côté du composant semi-conducteur bipolaire (2) sur la même plaque métallique (14) ou sur la face, orientée vers le composant semi-conducteur bipolaire (2), d'une deuxième plaque de support (30) au-dessus du composant semi-conducteur bipolaire (2), les liaisons électriques entre les deux composants semi-conducteurs étant réalisées par contact direct et/ou à l'aide d'étriers de contact (4, 19), et qu'au moins la face éloignée du composant semi-conducteur bipolaire de la première plaque de support (14) peut être mise en contact avec un dissipateur thermique (20).

2.- Module semi-conducteur de puissance suivant la revendication 1, caractérisé en ce que le composant semiconducteur MOS (1) est disposé directement sur la première plaque de support métallique (14) à côté du composant semiconducteur bipolaire (2) (Fig. 2).

3. Module semi-conducteur de puissance suivant la revendication 2, caractérisé en ce que les premières connexions principales (3, 5) des composants semiconducteurs (1, 2) sont connectées directement l'une à l'autre par l'intermédiaire d'un premier étrier de contact (4), que la deuxième connexion principale (9) du composant semi-conducteur bipolaire est reliée à une première borne de courant principal (10) du module, que la connexion de commande (8) du composant semi-conducteur bipolaire est reliée à la première plaque de support (14) par l'intermédiaire d'un deuxième étrier de liaison situé en-dessous du premier étrier, à une certaine distance de celui-ci, la première plaque de support (14) formant la deuxième borne de courant principal (11) du module, et que la connexion de commande (12) du composant semiconducteur MOS est reliée à une autre borne qui est la borne de commande (13) du module.

4.- Module semi-conducteur de puissance suivant la revendication 3, caractérisé en ce qu'une diode Zener (25), dont la connexion d'anode (26) est située directement sur la première plaque de support (14) et dont la connexion de cathode est connectée au deuxième étrier (7), est connectée dans le trajet du deuxième étrier de liaison (7).

5.- Module semi-conducteur de puissance suivant l'une quelconque des revendications 1 à 4, caractérisé en ce que le composant semi-conducteur bipolaire est un montage de transistors Darlington (2") ou un thyristor commandé par le champ (2') dont la connexion de commande (8', 8") est reliée à une deuxième borne de commande (28) séparée.

6.- Module semi-conducteur de puissance suivant la revendication 1, caractérisé en ce que la deuxième plaque de support (30) est en métal et l'espacement entre la première (15) et la deuxième plaque de support (30) est déterminée par les deux composants semi-conducteurs (1, 2) eux-mêmes et/ou par des organes d'espacement en matière isolante.

7.- Module semi-conducteur de puissance suivant la revendication 6, caractérisé en ce que le composant semiconducteur bipolaire est un thyristor (2 ; 2'), le composant semi-conducteur MOS est un transistor à effet de champ MOS de puissance et la connexion de cathode (5) du thyristor (2 ; 2') est reliée directement à la connexion de source (3) du transistor à effet de champ MOS (1) par une couche intermédiaire (22) électriquement conductrice.

8.- Module semi-conducteur de puissance suivant la revendication 6 ou 7, caractérisé en ce que les bornes de connexion (10, 11, 13) de ce module sortent latéralement et que les deux faces libres des plaques de support (14, 30) peuvent chacune être mises en contact avec un dissipateur thermique (20, 21).

1 / 1

FIG.1  FIG.4  FIG.5

FIG.2

FIG.3

FIG.6